# EUROPEAN PATENT SPECIFICATION

(11) **EP 3 250 016 B1**
(45) Date of publication and mention of the grant of the patent: **17.07.2019**
(21) Application number: 16171475.3
(22) Date of filing: 26.05.2016
(51) Int. Cl.: H05K 7/14, H05K 7/18, H02M 7/00

(54) **ELECTRICAL DEVICE**
ELEKTRISCHE VORRICHTUNG
DISPOSITIF ÉLECTRIQUE

(43) Date of publication of application: 29.11.2017
(73) Proprietor: ABB Schweiz AG, 5400 Baden (CH)
(72) Inventor: Seväkivi, Pertti, 00380 Helsinki (FI); Björkman, Niko, 00380 Helsinki (FI)
(74) Representative: Kolster Oy Ab

(56) References cited:
- EP-A1- 2 816 716
- WO-A1-2013/003668
- US-A1- 2012 176 732
- US-A1- 2014 133 070

## Description

### FIELD OF THE INVENTION

The invention relates to an electrical device comprising a power converter and a controller element for controlling the power converter.

In a known power converter assembly a location of a controller element adapted to control a power converter of the assembly is simply determined based on connections between different components selected on the grounds of their electrotechnical properties. In the known power converter assembly, the controller element of the power converter is located deep inside the power converter assembly thereby making maintenance work relating to the controller element difficult and time-consuming.

An example of a known electrical device is described in publication WO 2013/003668.

### BRIEF DESCRIPTION OF THE INVENTION

An object of the present invention is to provide an electrical device so as to alleviate the above disadvantage. The objects of the invention are achieved by an electrical device which is characterized by what is stated in the independent claim. The preferred embodiments of the invention are disclosed in the dependent claims.

The invention is based on the idea of providing an electrical device with a wall which is pivotally connected to the frame of the electrical device, the wall being adapted to pivot between a first position in which the wall is adapted to protect the controller element, and a second position which provides an access to the controller element for maintenance and repair. In an embodiment the controller element is attached to an inner surface of the pivoting wall.

An advantage of the electrical device of the invention is that the controller element is easily accessible simply by turning the wall into an open position.

### BRIEF DESCRIPTION OF THE DRAWINGS

In the following the invention will be described in greater detail by means of preferred embodiments with reference to the attached drawings, in which
Figure 1 shows an electrical device assembly comprising an electrical device according to an embodiment of the invention;
Figure 2 shows the electrical device assembly of Figure 1 with a front wall of the electrical device in an open position;
Figure 3A shows the electrical device of Figure 1 in a partially disassembled state;
Figure 3B shows the partially disassembled electrical device of Figure 3A from a different direction; and
Figures 4A and 4B illustrate assembling of the electrical device of Figure 3A.

### DETAILED DESCRIPTION OF THE INVENTION

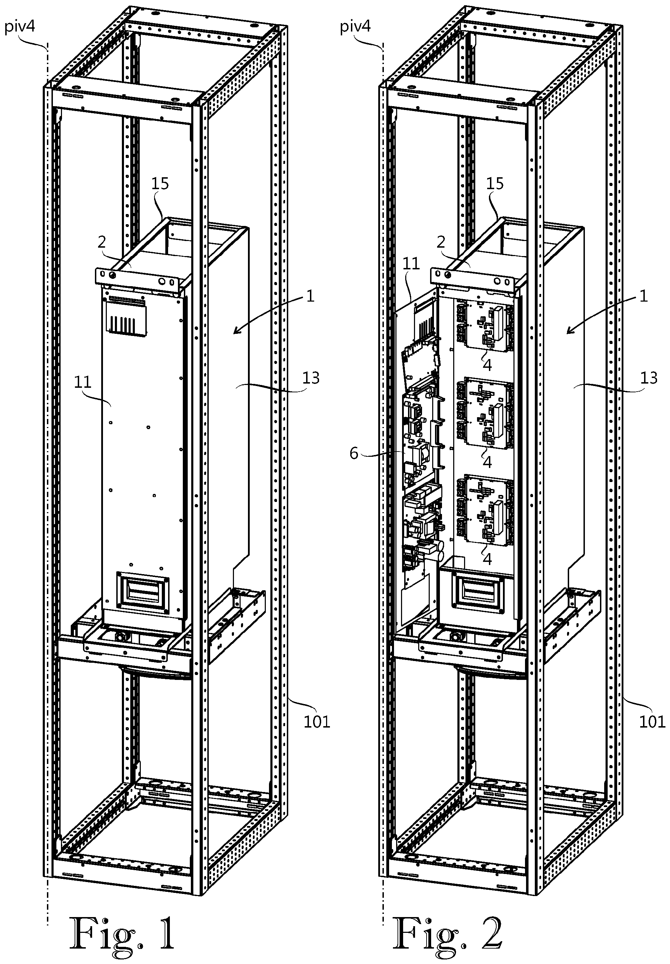

Figure 1 shows an electrical device assembly comprising a rack 101 of an electric cabinet, and an electrical device 1 mounted in the rack 101. In a use situation the electric cabinet comprises side walls and an openable door mounted on the rack 101. The electric cabinet defines a mounting space that accommodates the electrical device 1. The openable door is adapted to provide access into the mounting space in an open position of the openable door. The side walls and the openable door have been omitted from Figure 1 in order to provide a better view of the electrical device 1.

The electrical device 1 comprises a frame 2, a first wall 11 connected to the frame 2, a power converter adapted to convert electric energy from one form to another, and a controller adapted to control the power converter. The controller is communicatively and electrically connected to components mounted on the frame 2. The first wall 11 is pivotally connected to the frame 2 about a first pivoting axis such that the first wall 11 is adapted to pivot between a first position shown in Figure 1, and a second position shown in Figure 2. There is a hinge between the first wall 11 and the frame 2, the hinge providing the pivotal connection between the first wall 11 and the frame 2.

The controller comprises a controller element 6. In the first position the first wall 11 is adapted to protect the controller element 6. The second position of the first wall 11 provides an access to the controller element 6 for maintenance and repair. The first position of the first wall 11 can be considered as a closed position, and the second position of the first wall 11 can be considered as an open position.

The controller element 6 is attached to the first wall 11, on an inner surface of the first wall 11. The controller element 6 is adapted to pivot with the first wall 11. The controller element 6 comprises a circuit board defining a circuit board plane which is parallel to a first wall plane defined by the first wall 11.

The inner surface of the first wall 11 is a surface of the first wall 11 which faces towards inside of the electrical device 1 when the first wall 11 is in the first position. An outer surface of the first wall 11 is a surface of the first wall 11 which faces towards outside of the electrical device 1 when the first wall 11 is in the first position. The outer surface of the first wall 11 can be seen in Figure 1.

The power converter comprises three power converter elements 4. The power converter elements 4 are attached to the frame 2. Each of the power converter elements 4 comprises a plurality of controllable semiconductor switches adapted for the power conversion function of the power converter. The controller is adapted to control the controllable semiconductor switches selectively into conducting state and non-conducting state in order to convert electric energy from one form to another. The power converter elements 4 define a power converter element plane which is parallel to the first wall plane when the first wall 11 is in the first position thereof. Distance between the power converter element plane and the circuit board plane is small when the first wall 11 is in the first position thereof.

Figure 2 shows that the second position of the first wall 11 provides an access to the power converter elements 4 for maintenance and repair. In the second position of the first wall 11 the first wall plane is in an angle relative to the power converter element plane, the angle being over 90°. When the first wall 11 is in the second position, inspecting and replacing the power converter elements 4 is easy.

In an alternative embodiment a controller element is located in a corresponding position as the power converter elements 4 in Figure 2. In the alternative embodiment the controller element is attached to a frame of an electrical device, and a first wall is pivotally connected to the frame about a first pivoting axis such that the first wall is adapted to pivot between a first position and a second position. In the first position the first wall is adapted to protect the controller element by covering the controller element. In the second position the first wall does not cover the controller element, and provides an access to the controller element for maintenance and repair.

The power converter of the electrical device 1 comprises a frequency converter. In an alternative embodiment a power converter comprises an inverter, a rectifier, a DC-to-DC converter, or some other type of power converter adapted to convert electric energy from one form to another.

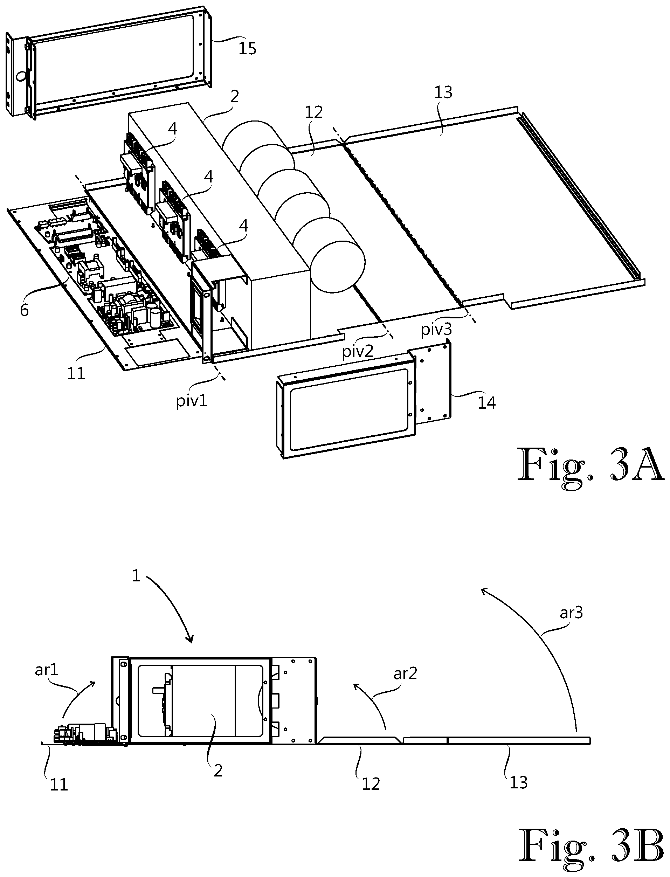

Figure 3A shows the electrical device 1 of Figure 1 in a partially disassembled state. In Figure 3A the first pivoting axis about which the first wall 11 is pivotally connected to the frame 2 is denoted with reference sign piv1. The electrical device 1 comprises a second wall 12 pivotally connected to the frame 2 about a second pivoting axis piv2, such that the second wall 12 is adapted to pivot between a first position and a second position relative to the frame 2. There is a hinge between the second wall 12 and the frame 2, the hinge providing the pivotal connection between the second wall 12 and the frame 2. The second pivoting axis piv2 is substantially parallel to the first pivoting axis piv1.

The electrical device 1 comprises a third wall 13 pivotally connected to the second wall 12 about a third pivoting axis piv3. There is a hinge between the third wall 13 and the second wall 12, the hinge providing the pivotal connection between the third wall 13 and the second wall 12. The third wall 13 is adapted to pivot between a first position and a second position relative to the second wall 12. The second pivoting axis piv2 is substantially parallel to the third pivoting axis piv3.

The first wall 11 defines a first wall plane, the second wall 12 defines a second wall plane, and the third wall 13 defines a third wall plane. In Figure 3A the first wall 11 and the second wall 12 are in their second positions relative to the frame 2, and the third wall 13 is in the second position relative to the second wall 12, wherein the first wall plane, the second wall plane and the third wall plane are coplanar planes. Figure 3A shows that the position where the first wall 11, the second wall 12 and the third wall 13 are located on a same plane provides good access to components of the electrical device 1. When the first wall 11, the second wall 12 and the third wall 13 are located on a same plane, installing components into the frame 2 is easy.

The electrical device 1 comprises a fourth wall 14 and a fifth wall 15 which are connected to the frame 2 in the assembled state of the electrical device 1 shown in Figure 1. In Figure 3A the fourth wall 14 and the fifth wall 15 are detached from the frame 2. Figure 3A shows that the fourth wall 14 and the fifth wall 15 are substantially open walls which can be considered as rectangular framing elements.

In the assembled state of the electrical device 1 the fourth wall 14 and the fifth wall 15 define end walls of the electrical device. The fourth wall 14 defines a fourth wall plane and the fifth wall 15 defines a fifth wall plane. The fourth wall plane and the fifth wall plane are parallel to each other and located at a distance from each other. The electrical device 1 is adapted such that when the first wall 11 and the second wall 12 are in their first positions relative to the frame 2, and the third wall 13 is in the first position relative to the second wall 12, the fourth wall plane and the fifth wall plane extend perpendicular to the first wall plane, the second wall plane and the third wall plane. The controller and the power converter are located inside a space defined by the first wall 11, the second wall 12, the third wall 13, the fourth wall 14 and the fifth wall 15.

It should be noted that in the assembled state of the electrical device 1 it is not possible to turn the second wall 12 about the second pivoting axis piv2, or the third wall 13 about the third pivoting axis piv3 because the third wall 13 is connected by screws (not depicted) to the fourth wall 14 and the fifth wall 15. However, if said screw connections were opened, it would again be possible to pivot the second wall 12 and the third wall 13 about their respective pivoting axes. Herein a pivotal connection between two components means that there is a hinge between the two components. It is not required that pivoting the two components relative to each other is possible during any situation.

Figure 3B shows the partially disassembled electrical device of Figure 3A from a direction perpendicular to the fourth wall plane. Arrows ar1, ar2 and ar3 illustrate directions in which the first wall 11, the second wall 12 and the third wall 13 are turned during assembly of the electrical device.

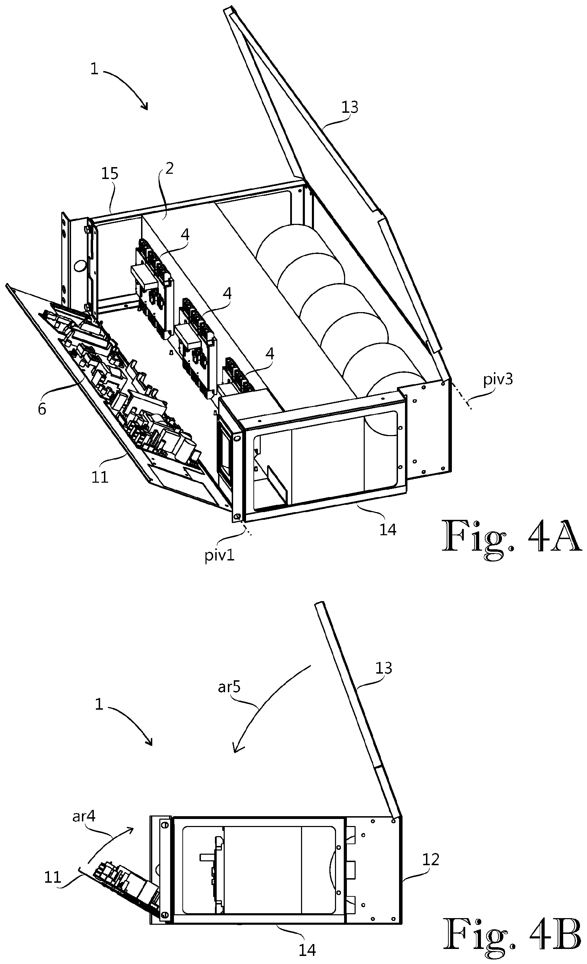

Figure 4A illustrates assembling of the electrical device of Figure 3A. In Figure 4A the first wall 11 is between its first and second positions. The second wall 12 is in its first position relative to the frame 2. The third wall 13 is between its first and second positions. Figure 4B shows the electrical device 1 of Figure 4A from a direction perpendicular to the fourth wall plane. Arrows ar4 and ar5 illustrate directions in which the first wall 11 and the third wall 13 are turned during final assembly of the electrical device 1.

As defined above, Figure 1 shows the electrical device 1 in the assembled state thereof. In the assembled state the first wall 11 and the second wall 12 are in their first positions relative to the frame 2, the third wall 13 is in the first position relative to the second wall 12, and the first wall plane and the second wall plane are substantially parallel to each other, and the third wall plane extends substantially perpendicular to the first wall plane and the second wall plane such that the first wall 11 forms a front wall of the electrical device, the second wall 12 forms a back wall of the electrical device, and the third wall 13 forms a side wall of the electrical device 1.

Although the door of the electric cabinet is not shown in Figure 1, a pivoting axis of the door is denoted with reference sign piv4. When the door of the electric cabinet is in its closed position, a door plane defined by the door is parallel to the first wall plane defined by the first wall 11 in its first position. When the door of the electric cabinet is in its open position, the door plane is parallel to the first wall plane defined by the first wall 11 in its second position. When the door of the electric cabinet is in the open position and the first wall 11 is in the second position, the controller element 6 of the electrical device 1 is accessible for maintenance and repair.

It will be obvious to a person skilled in the art that the inventive concept can be implemented in various ways. The invention and its embodiments are not limited to the examples described above but may vary within the scope of the claims.

## Claims

1. An electrical device comprising:
a frame (2);
a first wall (11) connected to the frame (2);
a power converter adapted to convert electric energy from one form to another, the power converter comprising at least one power converter element (4); and
a controller adapted to control the power converter, the controller comprising at least one controller element (6),
wherein the first wall (11) is pivotally connected to the frame (2) about a first pivoting axis (piv1) such that the first wall (11) is adapted to pivot between a first position in which the first wall (11) is adapted to protect the at least one controller element (6), and a second position which is adapted to provide an access to the at least one controller element (6) for maintenance and repair, and
the electrical device (1) comprises a second wall (12) pivotally connected to the frame (2) about a second pivoting axis (piv2), such that the second wall (12) is adapted to pivot about the second pivoting axis (piv2) between a first position and a second position relative to the frame (2), the second pivoting axis (piv2) being substantially parallel to the first pivoting axis (piv1),
**characterized in that** the electrical device (1) comprises a third wall (13) pivotally connected to the second wall (12) about a third pivoting axis (piv3), the third wall (13) is adapted to pivot about the third pivoting axis (piv3) between a first position and a second position relative to the second wall (12), and the second pivoting axis (piv2) is substantially parallel to the third pivoting axis (piv3).

2. An electrical device according to claim 1, **characterized in that** the second position of the first wall (11) is further adapted to provide access to the at least one power converter element (4).

3. An electrical device according to claim 1 or 2, **characterized in that** the at least one controller element (6) is attached to the first wall (11).

4. An electrical device according to any one of the preceding claims, **characterized in that** the first wall (11) defines a first wall plane, the second wall (12) defines a second wall plane, and the third wall (13) defines a third wall plane, and the electrical device (1) is adapted such that when the first wall (11) and the second wall (12) are in their second positions relative to the frame (2), and the third wall (13) is in the second position relative to the second wall (12), the first wall plane, the second wall plane and the third wall plane are coplanar planes.

5. An electrical device according to claim 4, **characterized in that** the electrical device (1) is adapted such that when the first wall (11) and the second wall (12) are in their first positions relative to the frame (2), and the third wall (13) is in the first position relative to the second wall (12), the first wall plane and the second wall plane are substantially parallel to each other and the third wall plane extends substantially perpendicular to the first wall plane and the second wall plane such that the first wall (11) forms a front wall of the electrical device, the second wall (12) forms a back wall of the electrical device, and the third wall (13) forms a side wall of the electrical device.

6. An electrical device according to any one of the preceding claims, **characterized in that** the power converter comprises an inverter, a rectifier, a frequency converter or a DC-to-DC converter.

7. An electrical device according to any one of the preceding claims, **characterized in that** the at least one power converter element (4) comprises a plurality of controllable semiconductor switches.

8. An electrical device assembly comprising:
an electric cabinet defining a mounting space adapted to accommodate an electrical device, the electric cabinet comprising an openable door adapted to provide access into the mounting space in an open position of the door; and
an electrical device mounted in the electric cabinet,
**characterized in that** the electrical device is an electrical device (1) according to any one of claims 1 to 7, and the electrical device assembly is adapted such that when the door of the electric cabinet is in the open position and the first wall (11) is in the second position, the at least one controller element (6) of the electrical device (1) is accessible for maintenance and repair.

## Patentansprüche

1. Elektrische Vorrichtung, die Folgendes umfasst:
einen Rahmen (2);
eine erste Wand (11), die mit dem Rahmen (2) verbunden ist;
einen Leistungswandler, der gestaltet ist, um elektrische Energie von einer Form in eine andere umzuwandeln, wobei der Leistungswandler mindestens ein Leistungswandlerelement (4) umfasst; und
eine Steuereinrichtung, die gestaltet ist, um den Leistungswandler zu steuern, wobei die Steuereinrichtung mindestens ein Steuereinrichtungselement (6) umfasst,
wobei die erste Wand (11) um eine erste Schwenkachse (piv1) schwenkbar mit dem Rahmen (2) verbunden ist, derart, dass die erste Wand (11) gestaltet ist, um zwischen einer ersten Position, in der die erste Wand (11) gestaltet ist, um das mindestens eine Steuereinrichtungselement (6) zu schützen, und einer zweiten Position zu schwenken, die gestaltet ist, um einen Zugang zu dem mindestens einen Steuereinrichtungselement (6) für Wartung und Reparatur bereitzustellen, und
die elektrische Vorrichtung (1) eine zweite Wand (12) umfasst, die um eine zweite Schwenkachse (piv2) schwenkbar mit dem Rahmen (2) verbunden ist, derart dass die zweite Wand (12) gestaltet ist, um um die zweite Schwenkachse (piv2) zwischen einer ersten Position und einer zweiten Position in Bezug zu dem Rahmen (2) zu schwenken, wobei die zweite Schwenkachse (piv2) im Wesentlichen parallel zur ersten Schwenkachse (piv1) ist,
**dadurch gekennzeichnet, dass** die elektrische Vorrichtung (1) eine dritte Wand (13) umfasst, die um eine dritte Schwenkachse (piv3) schwenkbar mit der zweiten Wand (12) verbunden ist, die dritte Wand (13) gestaltet ist, um um die dritte Schwenkachse (piv3) zwischen einer ersten Position und einer zweiten Position in Bezug zu der zweiten Wand (12) zu schwenken, und die zweite Schwenkachse (piv2) im Wesentlichen parallel zur dritten Schwenkachse (piv3) ist.

2. Elektrische Vorrichtung nach Anspruch 1, **dadurch gekennzeichnet, dass** die zweite Position der ersten Wand (11) ferner gestaltet ist, um Zugang zu dem mindestens einen Leistungswandlerelement (4) bereitzustellen.

3. Elektrische Vorrichtung nach Anspruch 1 oder 2, **dadurch gekennzeichnet, dass** das mindestens eine Steuereinrichtungselement (6) an der ersten Wand (11) angebracht ist.

4. Elektrische Vorrichtung nach einem der vorhergehenden Ansprüche, **dadurch gekennzeichnet, dass** die erste Wand (11) eine erste Wandebene definiert, die zweite Wand (12) eine zweite Wandebene definiert und die dritte Wand (13) eine dritte Wandebene definiert, und die elektrische Vorrichtung (1) derart gestaltet ist, dass, wenn die erste Wand (11) und die zweite Wand (12) sich in ihren zweiten Positionen in Bezug zu dem Rahmen (2) befinden und die dritte Wand (13) sich in der zweiten Position in Bezug zu der zweiten Wand (12) befindet, die erste Wandebene, die zweite Wandebene und die dritte Wandebene koplanare Ebenen sind.

5. Elektrische Vorrichtung nach Anspruch 4, **dadurch gekennzeichnet, dass** die elektrische Vorrichtung (1) derart gestaltet ist, dass, wenn die erste Wand (11) und die zweite Wand (12) sich in ihren ersten Positionen in Bezug zu dem Rahmen (2) befinden und die dritte Wand (13) sich in der ersten Position in Bezug zu der zweiten Wand (12) befindet, die erste Wandebene und die zweite Wandebene im Wesentlichen parallel zueinander sind und die dritte Wandebene sich im Wesentlichen senkrecht zu der ersten Wandebene und der zweiten Wandebene erstreckt, derart dass die erste Wand (11) eine Vorderwand der elektrischen Vorrichtung bildet, die zweite Wand (12) eine Rückwand der elektrischen Vorrichtung bildet, und die dritte Wand (13) eine Seitenwand der elektrischen Vorrichtung bildet.

6. Elektrische Vorrichtung nach einem der vorhergehenden Ansprüche, **dadurch gekennzeichnet, dass** der Leistungswandler einen Wechselrichter, einen Gleichrichter, einen Frequenzwandler oder einen Gleichstrom-Gleichstrom-Wandler umfasst.

7. Elektrische Vorrichtung nach einem der vorhergehenden Ansprüche, **dadurch gekennzeichnet, dass** das mindestens eine Leistungswandlerelement (4) mehrere steuerbare Halbleiterschalter umfasst.

8. Elektrische Vorrichtungsbaugruppe, die Folgendes umfasst:
einen Schaltschrank, der einen Montageraum definiert, der gestaltet ist, um eine elektrische Vorrichtung aufzunehmen, wobei der Schaltschrank eine öffenbare Tür umfasst, die gestaltet ist, um in einer offenen Position der Tür Zugang zu dem Montageraum bereitzustellen; und
eine elektrische Vorrichtung, die in dem Schaltschrank montiert ist,
**dadurch gekennzeichnet, dass** die elektrische Vorrichtung eine elektrische Vorrichtung (1) nach einem der Ansprüche 1 bis 7 ist und die elektrische Vorrichtungsbaugruppe derart gestaltet ist, dass, wenn die Tür des Schaltschranks sich in der offenen Position befindet und die erste Wand (11) sich in der zweiten Position befindet, das mindestens eine Steuereinrichtungselement (6) der elektrischen Vorrichtung (1) für Wartung und Reparatur zugänglich ist.

## Revendications

1. Dispositif électrique comprenant :
un cadre (2) ;
une première paroi (11) reliée au cadre (2) ;
un convertisseur de puissance conçu pour convertir l'énergie électrique d'une forme en une autre, le convertisseur de puissance comprenant au moins un élément de convertisseur de puissance (4) ; et
un contrôleur conçu pour commander le convertisseur de puissance, le contrôleur comprenant au moins un élément de contrôleur (6),
dans lequel la première paroi (11) est reliée de manière pivotante au cadre (2) autour d'un premier axe de pivotement (piv1) de sorte que la première paroi (11) est conçue pour pivoter entre une première position, dans laquelle la première paroi (11) est conçue pour protéger ledit au moins un élément de contrôleur (6), et une deuxième position qui est conçue pour fournir un accès audit au moins un élément de contrôleur (6) pour une maintenance et une réparation, et
le dispositif électrique (1) comprend une deuxième paroi (12) reliée de manière pivotante au cadre (2) autour d'un deuxième axe de pivotement (piv2), de sorte que la deuxième paroi (12) est conçue pour pivoter autour du deuxième axe de pivotement (piv2) entre une première position et une deuxième position par rapport au cadre (2), le deuxième axe de pivotement (piv2) étant sensiblement parallèle au premier axe de pivotement (piv1),
**caractérisé en ce que** le dispositif électrique (1) comprend une troisième paroi (13) reliée de manière pivotante à la deuxième paroi (12) autour d'un troisième axe de pivotement (piv3), la troisième paroi (13) est conçue pour pivoter autour du troisième axe de pivotement (piv3) entre une première position et une deuxième position par rapport à la deuxième paroi (12), et le deuxième axe de pivotement (piv2) est sensiblement parallèle au troisième axe de pivotement (piv3).

2. Dispositif électrique selon la revendication 1, **caractérisé en ce que** la deuxième position de la première paroi (11) est en outre conçue pour fournir un accès audit au moins un élément de convertisseur de puissance (4).

3. Dispositif électrique selon la revendication 1 ou 2, **caractérisé en ce que** ledit au moins un élément de contrôleur (6) est attaché à la première paroi (11).

4. Dispositif électrique selon l'une quelconque des revendications précédentes, **caractérisé en ce que** la première paroi (11) définit un premier plan de paroi, la deuxième paroi (12) définit un deuxième plan de paroi, et la troisième paroi (13) définit un troisième plan de paroi, et le dispositif électrique (1) est conçu de sorte que, lorsque la première paroi (11) et la deuxième paroi (12) sont dans leurs deuxièmes positions par rapport au cadre (2), et que la troisième paroi (13) est dans la deuxième position par rapport à la deuxième paroi (12), le premier plan de paroi, le deuxième plan de paroi et le troisième plan de paroi sont des plans coplanaires.

5. Dispositif électrique selon la revendication 4, **caractérisé en ce que** le dispositif électrique (1) est conçu de sorte que, lorsque la première paroi (11) et la deuxième paroi (12) sont dans leurs premières positions par rapport au cadre (2), et que la troisième paroi (13) est dans la première position par rapport à la deuxième paroi (12), le premier plan de paroi et le deuxième plan de paroi sont sensiblement parallèles l'un à l'autre et le troisième plan de paroi s'étend sensiblement perpendiculairement au premier plan de paroi et au deuxième plan de paroi de sorte que la première paroi (11) forme une paroi avant du dispositif électrique, la deuxième paroi (12) forme une paroi arrière du dispositif électrique, et la troisième paroi (13) forme une paroi latérale du dispositif électrique.

6. Dispositif électrique selon l'une quelconque des revendications précédentes, **caractérisé en ce que** le convertisseur de puissance comprend un onduleur, un redresseur, un convertisseur de fréquence ou un convertisseur continu-continu.

7. Dispositif électrique selon l'une quelconque des revendications précédentes, **caractérisé en ce que** ledit au moins un élément de convertisseur de puissance (4) comprend une pluralité de commutateurs à semi-conducteurs pouvant être commandés.

8. Ensemble de dispositif électrique comprenant :
une armoire électrique définissant un espace de montage conçu pour loger un dispositif électrique, l'armoire électrique comprenant une porte ouvrable conçue pour fournir un accès à l'espace de montage dans une position ouverte de la porte ; et
un dispositif électrique monté dans l'armoire électrique,
**caractérisé en ce que** le dispositif électrique est un dispositif électrique (1) selon l'une quelconque des revendications 1 à 7, et l'ensemble de dispositif électrique est conçu de sorte que, lorsque la porte de l'armoire électrique est dans la position ouverte et que la première paroi (11) est dans la deuxième position, ledit au moins un élément de contrôleur (6) du dispositif électrique (1) soit accessible pour une maintenance et une réparation.
